# EUROPÄISCHE PATENTSCHRIFT

(11) **EP 0 959 558 B1**
(45) Veröffentlichungstag und Bekanntmachung des Hinweises auf die Patenterteilung: **17.10.2001**
(21) Anmeldenummer: 99201440.7
(22) Anmeldetag: 07.05.1999
(51) Int. Cl.: H03D 3/24, H04N 5/60, H04B 1/16, H04H 5/00

(54) **Stereo/Zweiton-Demodulator**
Stereo/bi-channel demodulator
Démodulateur stéréo/bi-canal

(30) Priorität: 16.05.1998 DE 19822100
(43) Veröffentlichungstag der Anmeldung: 24.11.1999
(73) Patentinhaber: Philips Corporate Intellectual Property GmbH, 52064 Aachen (DE); Koninklijke Philips Electronics N.V., 5621 BA Eindhoven (NL)
(72) Erfinder: Brilka, Joachim, c/o Philips Patentverwaltung GmbH, 22335 Hamburg (DE)
(74) Vertreter: von Laue, Hanns-Ulrich, Dipl.-Ing.

(56) Entgegenhaltungen:
- EP-A- 0 645 891
- EP-A- 0 674 399
- DE-A- 3 319 237
- PATENT ABSTRACTS OF JAPAN vol. 097, no. 002, 28. Februar 1997 (1997-02-28) & JP 08 274733 A (NEC IC MICROCOMPUT SYST LTD;NEC CORP), 18. Oktober 1996 (1996-10-18)
- PATENT ABSTRACTS OF JAPAN vol. 008, no. 127 (E-250), 14. Juni 1984 (1984-06-14) & JP 59 037715 A (NIPPON DENKI KK), 1. März 1984 (1984-03-01)

## Beschreibung

Die Erfindung betrifft einen Stereo-/Zweiton-Demodulator, zur Demodulation eines Zwischenfrequenz-Signals, welches einem ersten und einem zweiten Tonträger aufmodulierte Stereo- oder Zweiton-Tonsignale enthält, wobei der zweite Tonträger eine niedrigere Amplitude als der erste Tonträger aufweist.

Ein Zwischenfrequenz-Signal, das gegebenenfalls auch ein Bildsignal enthalten kann, weist bei Übertragung eines Stereo- oder eines Zweiton-Signals zwei Tonträger auf, denen jeweils Tonsignalanteile aufmoduliert sind. Dabei weisen die beiden Tonträger je nach Übertragungsnorm nicht gleiche Amplitude auf. Einer der Tonträger kann gegenüber dem anderen bis zu 20 dB kleiner sein.

Bei bekannten Stereo-/Zweiton-Demodulatoren werden entweder dem Demodulator vorgeschaltete Keramik-Bandpaßfilter eingesetzt oder es werden innerhalb des Demodulators Bandpaßfilter vorgesehen. Da derartige Demodulatoren im Regelfall in integrierten Schaltkreisen aufgebaut werden, stören derartige Bandpaßfilter, da sie nicht innerhalb des IC's realisierbar sind, sondern durch zusätzliche externe Bauteile realisiert werden müssen, die nicht nur zusätzlichen externen Aufwand erfordern, sondern für die auch zusätzliche Anschlüsse am IC vorgesehen werden müssen, was ebenfalls störend ist.

Es ist Aufgabe der Erfindung, einen Stereo-/Zweiton-Demodulator anzugeben, der bei geringem Schaltungsaufwand vollständig integrierbar ist und der nur wenige Komponenten benötigt.

Diese Aufgabe wird erfindungsgemäß dadurch gelöst, daß ein erster und ein zweiter linearer Schmalband-Phasenregelkreis vorgesehen sind, welche jeweils eine eigene Frequenz-Selektivität aufweisen, wobei der erste Schmalband-Phasenregelkreis so ausgelegt ist, daß er auf die Frequenz des ersten Tonträgers rastet, und der zweite Schmalband-Phasenregelkreis so ausgelegt ist, daß er auf die Frequenz des zweiten Tonträgers rastet, daß dem ersten Schmalband-Phasenregelkreis eine erste Verstärkerstufe und dem zweiten Schmalband-Phasenregelkreis eine zweite Verstärkerstufe vorgeschaltet sind, welche jeweils das Eingangssignal des nachgeschalteten Phasenregelkreises auf eine Soll-Amplitude regeln, und daß eine Trägerunterdrückungsschaltung vorgesehen ist, in welcher ein Ausgangssignal mit einer Phasenlage von 0° oder 180° eines spannungsgesteuerten Oszillators des ersten Schmalband-Phasenregelkreises und das Eingangssignal des ersten Schmalband-Phasenregelkreises überlagert werden und welche als Ausgangssignal ein modifiziertes Zwischenfrequenz-Signal liefert, in welchem der erste Tonträger unterdrückt ist und welches auf die dem zweiten Schmalband-Phasenregelkreis vorgeschaltete zweite Verstärkerstufe gekoppelt ist.

Es sind also zwei linear arbeitende Schmalband-Phasenregelkreise vorgesehen, welche eine eigene Selektivität aufweisen. Damit diese Phasenregelkreise eine eigene Selektivität aufweisen können, dürfen den Phasenregelkreisen keine nicht linearen Schaltungselemente, insbesondere keine Begrenzer vorgeschaltet sein. Ferner wird das Eingangssignal der Phasenregelkreise bezüglich seiner Amplitude auf eine Sollamplitude geregelt; hierzu sind den Phasenregelkreisen jeweils vorgeschaltete Verstärkerstufen vorgesehen, welche eine derartige Amplitudenregelung aufweisen.

Der erste der Phasenregelkreise ist so ausgelegt, daß er auf die Frequenz des ersten Tonträgers rastet, der zweite Schmalband-Phasenregelkreis rastet hingegen auf die Frequenz des zweiten Tonträgers. Dies kann durch die Auslegung des Schleifenfilters und des damit erzielten Schleifenfrequenzganges des Phasenregelkreises wie auch durch entsprechende Auslegung des Oszillators innerhalb des Phasenregelkreises oder durch beispielsweise eine digitale Fanghilfsschaltung geschehen.

Darüber hinaus ist eine Trägerunterdrückungsschaltung vorgesehen, welche das Ausgangssignal des Oszillators des ersten Phasenregelkreises, der auf den ersten Tonträger gerastet ist, mit dem Eingangssignal des ersten Phasenregelkreises, in dem beide Tonträger vorhanden sind, überlagert. Dies geschieht mittels eines Ausgangssignals des Oszillators mit 0° oder 180° Phasenlage, das dem Eingangssignal des Phasenregelkreises additiv oder subtraktiv überlagert wird, so daß in diesem Signal sich die Anteile des ersten Tonträgers gegenseitig aufheben. Damit wird erreicht, daß in diesem Signal, das dem zweiten Phasenregelkreis zugeführt wird, die Amplitude des ersten Tonträgers stark unterdrückt wird. Somit wird dem zweiten Phasenregelkreis ein Signal zugeführt, in dem der zweite Tonträger gegenüber dem ersten so stark ist, daß der Phasenregelkreis in jedem Falle sicher auf den zweiten Tonträger rasten kann, auch wenn in dem Zwischenfrequenz-Signal der erste Tonträger deutlich größer als der zweite Tonträger war. Durch die Überlagerung in der Trägerunterdrückungsschaltung und die damit erzielte Unterdrückung des ersten Tonträgers ist der zweite Tonträger in jedem Falle wieder stärker als der erste Tonträger, so daß ein sicheres Einrasten der zweiten PLL auf den zweiten Tonträger stattfinden kann.

Damit ist erreicht worden, daß die beiden Phasenregelkreise unabhängig von den Amplitudenverhältnissen der beiden Tonträger sicher auf den Tonträger rasten können, auf den sie rasten sollen und nicht durch den anderen, gegebenenfalls in dem Zwischenfrequenz-Signal stärkeren Tonträger rasten.

Die Schaltung benötigt weder externe Keramikfilter noch Bandpaßfilter, so daß sie voll integrierbar ist. Sie ist darüber hinaus abgleichfrei und weist einen einfachen Schaltungsaufbau auf. Es wird eine gute Unterdrückung des ersten Tonträgers in dem dem zweiten Phasenregelkreis zugeführten Signal erreicht, so daß auch stark abweichende Tonträgeramplituden die Demodulation nicht stören. Darüber hinaus ist die Schaltung multistandardfähig, d.h. die Frequenzen der Tonträger können in Grenzen schwanken, so daß auch verschiedene Tonträgerfrequenzen verarbeitbar sind. Dies ist ohne zusätzliche Änderung der Schaltung oder einen Abgleich möglich.

Dies wird insbesondere dadurch erreicht, daß in der Trägerunterdrückungsschaltung durch Überlagerung des Ausgangssignals des Oszillators des ersten Phasenregelkreises mit dem Signal, in dem noch beide Tonträger vorhanden sind, unabhängig von der Frequenz des ersten Tonträgers immer eine Unterdrückung in dem Eingangssignal des zweiten Phasenregelkreises bzw. dessen vorgeschalteter Verstärkerstufe erreicht wird.

Gemäß einer Ausgestaltung der Erfindung ist vorgesehen, daß daß die Trägerunterdrückungsschaltung eine Überlagerungsstufe aufweist, auf deren ersten Eingang das Eingangssignal des ersten Schmalband-Phasenregelkreises und auf deren zweiten Eingang ein Ausgangssignal eines gesteuerten Verstärkers gekoppelt ist, dem eingangsseitig das Ausgangssignal mit 0°/180°-Phasenlage des spannungsgesteuerten Oszillators des ersten Schmalband-Phasenregelkreises zugeführt wird und dessen Verstärkung von einem Steuersignal abhängig ist, welches von einer Schaltung zur automatischen Verstärkungsregelung geliefert wird, der eingangsseitig das Ausgangssignal der Überlagerungsstufe und das Eingangssignal des gesteuerten Verstärkers zugeführt werden und welche das Steuersignal so generiert, daß in dem Ausgangssignal der Überlagerungsstufe der erste Tonträger mit minimaler Amplitude auftritt.

Durch diese zusätzliche Ausgestaltung der Erfindung wird erreicht, daß die beiden in der Trägerunterdrückungsschaltung und dort in der Überlagerungsstufe überlagerten Signale bezüglich ihrer Amplituden optimal so geregelt sind, daß bei der Überlagerung des Ausgangssignals des Oszillators des ersten Phasenregelkreises und dessen Eingangssignals eine optimale Unterdrückung der Amplitude des ersten Tonträgers stattfindet. Dies wird mittels der Schaltung zur automatischen Verstärkungsregelung und des regelbaren Verstärkers erreicht, so daß in dem Ausgangssignal der Trägerunterdrückungsschaltung die Amplitude des ersten Tonträgers optimal unterdrückt ist.

Dabei kann, wie nach einer weiteren Ausgestaltung der Erfindung vorgesehen ist, die Schaltung zur automatischen Verstärkungsregelung vorteilhaft so ausgelegt sein, daß die in der Trägerunterdrückungsschaltung vorgesehene Schaltung zur automatischen Verstärkungsregelung einen Synchron-Demodulator aufweist, welchem an einem ersten Eingang das Ausgangssignal der Überlagerungsstufe und an einem zweiten Eingang das Eingangssignal des gesteuerten Verstärkers, d.h. das Ausgangssignal mit 0°/180°-Phasenlage des spannungsgesteuerten Oszillators des ersten Schmalband-Phasenregelkreises zugeführt werden und welcher ausgangsseitig das Steuersignal liefert.

Da die Schmalband-Phasenregelkreise eine eigene Selektivität aufweisen müssen, dürfen ihnen keine nichtlinearen und insbesondere keine amplitudenbegrenzenden Elemente vorgeschaltet sein. Statt dessen ist, wie oben erläutert, eine Verstärkungsregelung vorgesehen. Diese kann vorteilhaft, wie gemäß einer weiteren Ausgestaltung der Erfindung vorgesehen ist, derart ausgelegt sein, daß die in den den beiden Schmalband-Phasenregelkreisen jeweils vorgeschalteten Verstärkungsstufen vorgenommene Verstärkungsregelung jeweils mittels eines gesteuerten Verstärkers erfolgt, dessen Verstärkung in Abhängigkeit eines Ausgangssignals eines Synchron-Demodulators einstellbar ist, welchem eingangsseitig das Eingangssignal des nachgeschalteten Phasenregelkreises sowie das Ausgangssignal mit 0°-Phasenlage dessen spannungsgesteuerten Oszillators zugeführt werden.

Da die beiden Phasenregelkreise bzw. deren Oszillatoren jeweils auf die Frequenzen der beiden Tonträger gerastet sind, kann das von den Phasenkomparatoren stammende Eingangssignal der Oszillatoren unmittelbar zur Gewinnung der demodulierten Niederfrequenz-Tonsignale herangezogen werden. Hierzu ist gemäß einer weiteren Ausgestaltung der Erfindung vorgesehen, daß Auskoppelstufen vorgesehen sind, welche demodulierte Niederfrequenz-Tonsignale liefern, wobei den Auskoppelstufen eingangsseitig jeweils das Eingangssignal des spannungsgesteuerten Oszillators einer der Phasenregelkreise zugeführt wird.

Gemäß einer weiteren Ausgestaltung der Erfindung ist vorgesehen, daß die Schmalband-Phasenregelkreise eingangsseitig jeweils einen Phasendiskriminator aufweisen, dessen Ausgangssignal jeweils auf ein Schleifenfilter und einen Steuereingang eines spannungsgesteuerten Oszillators gekoppelt ist, welcher an zwei Ausgängen Signale mit 0° oder 180° und mit 90° Phasenverschiebung liefert, wobei das Signal mit 90°-Phasenlage auf einen zweiten Eingang des Phasendiskriminators des Phasenregelkreises gekoppelt ist.

Die Oszillatoren liefern also einerseits ein Ausgangssignal mit 90° Phasenverschiebung, das in bekannter Weise dem Phasendiskriminator des Phasenregelkreises zugeführt wird. Darüber hinaus liefern sie ein Ausgangssignal entweder mit 0° oder mit 180° Phasenlage, das in der Trägerunterdrückungsschaltung zur Überlagerung eingesetzt wird und das aufgrund dieser Phasenlage entweder durch Subtraktion oder durch Addition mit dem Signale, in dem noch beide Tonträger vorhanden sind, eine solche Phasenlage aufweist, daß eine ideale Unterdrückung des ersten Tonträgers möglich ist. Das Ausgangssignal mit 0° Phasenlage wird außerdem für die automatische Verstärkungsregelung benötigt.

Die Auslegung der beiden Phasenregelkreise in der Weise, daß sie jeweils auf die Frequenz des für sie vorgesehenen Tonträgers rasten, kann vorteilhaft, wie gemäß einer weiteren Ausgestaltung der Erfindung vorgesehen ist, dadurch erreicht werden, daß die Schmalband-Phasenregelkreise jeweils eine digitale Fanghilfe aufweisen, welche die Frequenz des spannungsgesteuerten Oszillators in einem vorgegebenen Frequenzbereich hält.

Die Verschaltung der Ausgangssignale der Oszillatoren der Phasenregelkreise und die Verschaltung dieser Ausgangssignale des ersten Oszillators mit der Überlagerungsstufe innerhalb der Trägerunterdrückungsschaltung kann vorteilhaft gemäß einer weiteren Ausgestaltung der Erfindung in der Weise vorgenommen werden, daß das Ausgangssignal mit 0°/180°-Phasenlage des spannungsgesteuerten Oszillators des ersten Phasenregelkreises auf den zweiten Eingang der Überlagerungsstufe der Trägerunterdrückungsschaltung gekoppelt ist und daß die Ausgangssignale mit 90°-Phasenlage der spannungsgesteuerten Oszillatoren der beiden Phasenregelkreise jeweils auf einen Eingang des Phasendiskriminators der jeweils vorgeschalteten Verstärkungsstufe gekoppelt sind.

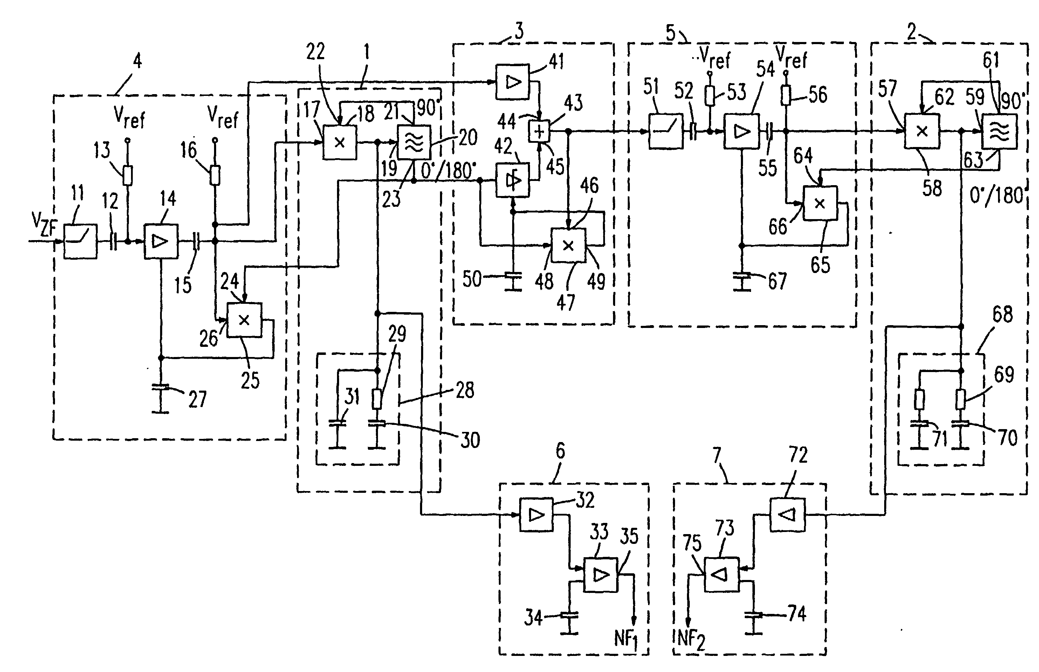

Nachfolgend wird ein Ausführungsbeispiel der Erfindung anhand der Zeichnung näher erläutert. Die einzige Figur zeigt einen Stereo-/Zweiton-Demodulator gemäß der Erfindung mit einer Überlagerungsstufe in Form eines Blockschaltbildes.

Der Schaltung wird eingangsseitig ein Zwischenfrequenz-Signal V_{ZF} zugeführt, das einen ersten und einen zweiten Tonträger aufweist, welchen ein Stereo- oder ein Zweiton-Signal aufmoduliert ist. Gegebenenfalls können diese beiden Tonträger stark abweichende Amplituden aufweisen, wobei die Differenz 20 dB und mehr betragen kann. Je nach Übertragungsnorm ist im Regelfall die Amplitude des ersten Tonträgers, welcher die niedrigere Frequenz aufweist, größer als die Frequenz des zweiten Tonträgers. In dem Zwischenfrequenz-Signal können gegebenenfalls auch noch Bildsignalanteile vorhanden sein. Diese können jedoch auch vorher durch in der Figur nicht dargestellte Schaltungselemente ausgefiltert sein.

In jedem Falle enthält das Zwischenfrequenz-Signal V_{ZF} die beiden Tonträger in Zwischenfrequenzlage.

Die Schaltung weist einen ersten Schmalband-Phasenregelkreis 1, der so ausgelegt ist, das er auf die Frequenz des ersten Tonträgers mit der niedrigeren Frequenz rastet, und eine zweiten Schmalband-Phasenregelkreis 2 auf, der auf die Frequenz des zweiten Tonträgers rastet. Den beiden Phasenregelkreisen 1 und 2 ist jeweils eine Verstärkerstufe 4 bzw. 5 vorgeschaltet, welcher der Amplitudenregelung und zusätzlich der Filterung dienen. Es ist ferner eine Trägerunterdrückungsschaltung 3 vorgesehen, mittels derer in dem Eingangssignal des zweiten Phasenregelkreises 5 eine Unterdrückung des ersten Tonträgers erfolgt. Zur Gewinnung der demodulierten Niederfrequenz-Tonsignale sind zwei Auskoppelstufen 6 und 7 vorgesehen.

Das der ersten Verstärkerstufe 4, die dem ersten Phasenregelkreis 1 vorgeschaltet ist, zugeführte Zwischenfrequenz-Signal V_{ZF} gelangt innerhalb der Verstärkerstufe 4 zunächst an ein Sallen- und Key-Filter 11, das ein Hochpaßfilter zweiter Ordnung darstellt. Dessen Ausgangssignal gelangt auf ein RC-Filter, das mittels einer Serienkapazität 12 und eines gegen ein Referenzpotential V_{ref} geschalteten Widerstandes 13 aufgebaut ist. Das Sallen- und Key-Filter 11 und das RC-Filter 12 und 13 bilden gemeinsam ein Hochpaßfilter dritter Ordnung, mittels dessen gegebenenfalls in dem Signal V_{ZF} vorhandene Bildsignalanteile unterdrückt werden können. Auch wird durch diese Filteranordnung erzielt, daß die bei 1/2 und einem Drittel der Frequenz der Tonträger auftretenden störenden Spektralanteile des Zwischenfrequenzsignals abgeschwächt werden. Innerhalb der Verstärkerstufe 4 gelangt das so vorgefilterte Zwischenfrequenz-Signal an einen gesteuerten Verstärker 14, dem wiederum ein RC-Filter mit einer Serienkapazität 15 und einen gegen ein Referenzpotential V_{ref} geschalteter Widerstand nachgeschaltet ist. Hinter dieser Filterung liefert die erste Verstärkerstufe ein Ausgangssignal, das einerseits einem Verstärker 41 in der Überlagerungsstufe und andererseits einem ersten Eingang 17 eines in dem ersten Phasenregelkreises 1 vorgesehenen Phasendiskriminators 18 zugeführt wird. Der Phasendiskriminator 18 liefert ausgangsseitig ein Steuersignal an einen ersten Eingang 19 eines Oszillators 20. Der Oszillator 20 stellt an einem ersten Ausgang 21 ein mit einer Phasenlage von 90° versehenes Ausgangssignal zur Verfügung, das einem zweiten Eingang des Phasendiskriminators 22 zugeführt wird. In Verbindung mit einem ferner vorgesehenen Schleifenfilter, auf das das Ausgangssignal des Phasendiskriminators geschaltet ist, ist durch diese Schaltungselemente ein Phasenregelkreis aufgebaut. Das Schleifenfilter 28 weist in Serienschaltung einen Widerstand 29 und eine Kapazität 30 auf, die gegen ein Bezugspotential geschaltet ist. Dieser Serienschaltung ist eine gegen Bezugspotential geschaltete Kapazität 31 parallelgeschaltet.

Innerhalb der Verstärkerstufe 4 ist ein Synchron-Demodulator 25 vorgesehen, dessen erstem Eingang das Ausgangssignal eines zweiten Ausganges 23 des Oszillators 20 des Phasenregelkreises 1 zugeführt wird. Das Ausgangssignal dieses zweiten Ausganges 23 weist im Gegensatz zu dem Ausgangssignal des Ausganges 21 des Oszillators 20 eine Phasenlage von 0° oder 180° auf.

Dem Synchron-Demodulator 25 wird ferner an einem zweiten Eingang 26 das Eingangssignal des Phasenregelkreises 1 zugeführt. Das Ausgangssignal des Synchron-Demodulators 25 wird auf einen Steuereingang des steuerbaren Verstärkers 14 rückgekoppelt. Dabei ist dieses Signal mittels einer Kapazität 27 auf Masse gekoppelt, so daß eine Tiefpaßfilterung erzielt wird. Mittels dieser Schaltung wird erreicht, daß die Amplitude des ersten Tonträgers, auf die der Oszillator 20 gerastet ist, geregelt wird. Es wird damit am Eingang des Phasenregelkreises 1 eine Soll-Amplitude dieses ersten Tonträgers eingestellt. Dies ist eine wesentliche Voraussetzung dafür, daß der Phasenregelkreis 1 eine eigene Selektivität aufweist. Er ist dabei so ausgelegt, daß er auf die Frequenz des ersten Tonträgers rastet. Dies kann gegebenenfalls in der Figur nicht näher dargestellter Weise dadurch noch unterstützt werden, daß eine digitale Fangschaltung vorgesehen ist, welche sicherstellt, daß der steuerbare Oszillator 20 nur in einem vorgegebenen Frequenzbereich arbeiten kann, der um die Frequenz des ersten Tonträgers herum vorgesehen ist. Damit wird zusätzlich sichergestellt, daß der erste Phasenregelkreis 1 auf die Frequenz des ersten Tonträgers rastet. Damit wird die Wirkung des Schleifenfilters 28, das durch den Phasenregelkreis auf ein Bandpaßfilter transformiert wird, unterstützt.

Innerhalb der Trägerunterdrückungsschaltung gelangt das Eingangssignal des ersten Phasenregelkreises 1, in dem noch beide Tonträger enthalten sind, auf den Verstärker 41. Das an dem zweiten Ausgang 23 des steuerbaren Oszillators 20 des ersten Phasenregelkreises 1 zur Verfügung gestellte Ausgangssignal mit 0° oder 180° Phasenlage gelangt innerhalb der Trägerunterdrückungsschaltung 3 an einen steuerbaren Verstärker 42. Dieses Signal hat die Frequenz des ersten Tonträgers, sofern, wovon im folgenden ausgegangen wird, der erste Phasenregelkreis auf diesen ersten Tonträger gerastet hat.

Innerhalb der Trägerunterdrückungsschaltung 3 ist eine Überlagerungsstufe 43 vorgesehen, der an einem ersten Eingang 44 das Ausgangssignal des Verstärkers 41 und an einem zweiten Eingang 45 das Ausgangssignal des steuerbaren Verstärkers 42 zugeführt wird.

Da der Oszillator 20 an seinem Ausgang 23 ein Signal zur Verfügung stellt, dessen Frequenz mit dem ersten Tonträger identisch ist und das relativ zu diesem eine definierte Phasenverschiebung von 0° oder 180° aufweist, kann in der Überlagerungsstufe 43 eine Überlagerung vorgenommen werden, mittels derer eine Auslöschung oder jedenfalls starke Unterdrückung des ersten Tonträgers gelingt. Weist beispielsweise das Ausgangssignal am zweiten Ausgang 23 des steuerbaren Oszillators 20 eine Phasenverschiebung von 0° auf, so wird in der Überlagerungsstufe 43 eine Subtraktion der beiden Signale vorgenommen. Weist hingegen das Ausgangssignal des steuerbaren Oszillators 20 eine Phasenverschiebung von 180° auf, wird in der Überlagerungsstufe eine additive Überlagerung vorgenommen. In beiden Fällen wird durch diese Überlagerung erreicht, daß der erste Tonträger in dem Ausgangssignal der Überlagerungsstufe 43 unterdrückt ist. Ansonsten bleibt das Signal unverändert. Damit ist in dem dem zweiten Phasenregelkreis 2 bzw. der diesem vorgeschalteten Verstärkerstufe 5 der erste Tonträger unterdrückt. Ansonsten handelt es sich um das unveränderte, vorgefilterte Zwischenfrequenz-Signal, das auch dem Phasenregelkreis 1 zugeführt wird.

Die oben erläuterte Überlagerung in der Überlagerungsstufe 43 und die damit vorgenommene Unterdrückung des ersten Tonträgers gelingt so gut, da die Phasenlage und die Frequenz der Eingangssignale der Überlagerungsstufe 43 genau definiert sind und damit eine exakte Unterdrückung des ersten Tonträgers gelingt. Um diese Unterdrückung noch zusätzlich zu verbessern, ist eine Amplitudenregelung vorgesehen. Dazu ist ein Synchron-Demodulator 47 vorgesehen, dem an einem ersten Eingang 46 das Ausgangssignal der Überlagerungsstufe 43 und an einem zweiten Eingang 48 das Ausgangssignal des zweiten Ausganges 23 des steuerbaren Oszillators 20 mit 0° oder 180° Phasenlage zugeführt wird. Der Synchron-Demodulator 47 liefert an einem Ausgang 49 ein Steuersignal an den steuerbaren Verstärker 42, welches zusätzlich mittels einer gegen ein Bezugspotential geschalteten Kapazität 50 tiefpaßgefiltert wird.

Der Synchron-Demodulator 47 nimmt eine Amplitudenregelung in der Weise vor, daß in dem Ausgangssignal der Überlagerungsstufe 43 die Signalanteile mit der Frequenz, die der steuerbare Oszillator 20 an seinem Ausgang 23 zur Verfugung stellt, auf ein Minimum geregelt wird. Dies geschieht dadurch, daß der steuerbare Verstärker 42 mittels des Ausgangssignals des Synchron-Demodulators 47 bezüglich seiner Verstärkung so eingestellt wird, daß in dem Ausgangssignal der Überlagerungsstufe 43 eine optimale Unterdrückung der Signalanteile mit der Frequenz des ersten Tonträgers erfolgt.

Dieses Ausgangssignal der Trägerunterdrückungsstufe 3 bzw. der innerhalb dieser vorgesehenen Überlagerungsstufe 43 gelangt innerhalb der zweiten Verstärkerstufe 5, die dem zweiten Phasenregelkreis 2 vorgeschaltet ist, auf ein Sallen- und Key-Filter 51.

Die zweite Verstärkerstufe 5 ist auch im übrigen identisch wie die erste Verstärkerstufe 4 aufgebaut. Sie weist also das Sallen- und Key-Filter 51, ein diesem nachgeschaltetes RC-Filter 52, 53, einen steuerbaren Verstärker 54 sowie einen Synchron-Demodulator 65 auf.

Der der zweiten Verstärkerstufe 5 nachgeschaltete zweite Phasenregelkreis 2 ist ebenfalls in identischer Weise aufgebaut wie der erste Phasenregelkreis 1 und weist einen Phasen-Diskriminator 58, einen steuerbaren Oszillator 60 sowie ein Schleifenfilter 68 mit einem Widerstand 69 und zwei Kapazitäten 69 und 71 auf.

Auch die innerhalb des zweiten Phasenregelkreises 2 und der diesem vorgeschalteten zweiten Verstärkerstufe 5 vorgenommene Verstärkungsregelung mittels des Synchron-Demodulators 65 erfolgt in gleicher Weise wie in dem ersten Phasenregelkreis 1 und der diesem vorgeschalteten ersten Verstärkerstufe 4.

Da in dem Eingangssignal der zweiten Verstärkerstufe 5 und damit auch in dem Eingangssignal des zweiten Phasenregelkreises 2 der erste Tonträger durch die Trägerunterdrückungsschaltung 3 unterdrückt ist, kann der zweite Phasenregelkreis 2 in optimaler Weise auf die Frequenz des zweiten Tonträgers rasten, auch wenn dieser in dem Zwischenfrequenz-Signal V_{ZF} ursprünglich eine deutlich niedrigere Amplitude aufwies als der erste Tonträger.

Die zur Gewinnung der Niederfrequenz-Tonträgersignale vorgesehenen Auskoppelstufen 6 und 7 können unmittelbar mit dem Eingangssignal der steuerbaren Oszillatoren 20 bzw. 60 arbeiten, da diese im gerasteten Zustand auf den ersten bzw. zweiten Tonträger gerastet sind und die Eingangssteuersignale die Frequenzabweichung von diesem Tonträger abgeben, die genau den übertragenen Stereo- bzw. Zweiton-Signalen entspricht.

Somit ist der ersten Auskoppelstufe 6 dieses Eingangssignal am Eingang 19 des steuerbaren Oszillators 20, das von dem Phasendiskriminator 18 stammt und das auf das Schleifenfilter 28 gekoppelt ist, zugeführt. Innerhalb der ersten Auskoppelstufe 6 gelangt dieses Signal zunächst an einen Verstärker 32, dessen Ausgangssignal auf einen weiteren Verstärker 33 gekoppelt ist. Es ist ferner eine Kapazität 34 vorgesehen, die zur Entkopplung des Niederfrequenz-Signals vom Gleichspannungsanteil dient. Der Verstärker 33 stellt an einem Ausgang 35 das dem ersten Tonträger aufmodulierte, niederfrequente und demodulierte Tonsignal NF₁ zur Verfügung.

Die zweite Auskoppelstufe 7 ist mit einem ersten Verstärker 72 und einem zweiten Verstärker 73 in gleicher Weise aufgebaut wie die erste Auskoppelstufe, jedoch wird der zweiten Auskoppelstufe 7 das Ausgangssignal des Phasendiskriminators 58 des zweiten Phasenregelkreises 2, das auf den Eingang 59 des steuerbaren Oszillators 60 gekoppelt ist und das ebenfalls auf das in dem zweiten Phasenregelkreis vorgesehene Schleifenfilter 78 gekoppelt ist, zugeführt. Somit liefert der Verstärker 73 an seinem Ausgang 75 das dem zweiten Tonträger aufmodulierte Tonsignal in demodulierter Form, das in der Figur mit NF₂ gekennzeichnet ist.

Im Ergebnis gelingt mittels dieser Schaltungsanordnung eine Modulation eines Stereo- oder Zweiton-Signals mit relativ einfacher Schaltungsanordnung, ohne daß externe Keramikfilter oder zusätzliche Bandpaßfilter innerhalb der Schaltung vorgesehen sein müßten. Vielmehr gelingt eine Unterdrückung des bezüglich seiner Amplitude wesentlich stärkeren ersten Tonträgers in dem dem zweiten Phasenregelkreis 2 zugeführten Signal durch die Trägerunterdrückungsschaltung 3.

## Patentansprüche

1. Stereo-/Zweiton-Demodulator, zur Demodulation eines Zwischenfrequenz-Signals, welches einem ersten und einem zweiten Tonträger aufmodulierte Stereo- oder Zweiton-Tonsignale enthält, wobei der zweite Tonträger eine niedrigere Amplitude als der erste Tonträger aufweist, **dadurch gekennzeichnet,**
**daß** ein erster (1) und ein zweiter (2) linearer Schmalband-Phasenregelkreis vorgesehen sind, welche jeweils eine eigene Frequenz-Selektivität aufweisen, wobei der erste Schmalband-Phasenregelkreis (1) so ausgelegt ist, daß er auf die Frequenz des ersten Tonträgers rastet, und der zweite Schmalband-Phasenregelkreis (2) so ausgelegt ist, daß er auf die Frequenz des zweiten Tonträgers rastet,
**daß** dem ersten Schmalband-Phasenregelkreis (1) eine erste Verstärkerstufe (4) und dem zweiten Schmalband-Phasenregelkreis (2) eine zweite Verstärkerstufe (5) vorgeschaltet sind, welche jeweils das Eingangssignal des nachgeschalteten Phasenregelkreises (1;2) auf eine Soll-Amplitude regeln,
und **daß** eine Trägerunterdrückungsschaltung (3) vorgesehen ist, in welcher ein Ausgangssignal mit einer Phasenlage von 0° oder 180° eines spannungsgesteuerten Oszillators (20) des ersten Schmalband-Phasenregelkreises (1) und das Eingangssignal des ersten Schmalband-Phasenregelkreises (1) überlagert werden und welche als Ausgangssignal ein modifiziertes Zwischenfrequenz-Signal liefert, in welchem der erste Tonträger unterdrückt ist und welches auf die dem zweiten Schmalband-Phasenregelkreis (2) vorgeschaltete zweite Verstärkerstufe (5) gekoppelt ist.

2. Anordnung nach Anspruch 1, **dadurch gekennzeichnet,**
**daß** die Trägerunterdrückungsschaltung (3) eine Überlagerungsstufe (43) aufweist, auf deren ersten Eingang (44) das Eingangssignal des ersten Schmalband-Phasenregelkreises (1) und auf deren zweiten Eingang (45) ein Ausgangssignal eines gesteuerten Verstärkers (42) gekoppelt ist, dem eingangsseitig das Ausgangssignal mit 0°/180°-Phasenlage des spannungsgesteuerten Oszillators (20) des ersten Schmalband-Phasenregelkreises (1) zugeführt wird und dessen Verstärkung von einem Steuersignal abhängig ist, welches von einer Schaltung zur automatischen Verstärkungsregelung geliefert wird, der eingangsseitig das Ausgangssignal der Überlagerungsstufe und das Eingangssignal des gesteuerten Verstärkers (42) zugeführt werden und welche das Steuersignal so generiert, daß in dem Ausgangssignal der Überlagerungsstufe (43) der erste Tonträger mit minimaler Amplitude auftritt.

3. Anordnung nach Anspruch 2, **dadurch gekennzeichnet,**
**daß** die in der Trägerunterdrückungsschaltung (3) vorgesehene Schaltung zur automatischen Verstärkungsregelung einen Synchron-Demodulator (47) aufweist, welchem an einem ersten Eingang (46) das Ausgangssignal der Überlagerungsstufe (43) und an einem zweiten Eingang (48) das Eingangssignal des gesteuerten Verstärkers (42) zugeführt werden und welcher ausgangsseitig (49) das Steuersignal liefert.

4. Anordnung nach Anspruch 1, **dadurch gekennzeichnet,**
**daß** die in den den beiden Schmalband-Phasenregelkreisen (1;2) jeweils vorgeschalteten Verstärkungsstufen (4;5) vorgenommene Verstärkungsregelung jeweils mittels eines gesteuerten Verstärkers (14;54) erfolgt, dessen Verstärkung in Abhängigkeit eines Ausgangssignals eines Synchron-Demdulators (25;65) einstellbar ist, welchem eingangsseitig das Eingangssignal des nachgeschalteten Phasenregelkreises (1;2) sowie das Ausgangssignal mit 0°-Phasenlage dessen spannungsgesteuerten Oszillators (20;60) zugeführt werden.

5. Anordnung nach Anspruch 4, **dadurch gekennzeichnet,**
**daß** in den Verstärkungsstufen (4;5) eine Hochpass-Filterung des ZwischenfrequenzSignals vorgesehen ist, vorzugsweise ein Filter dritter Ordnung mit einem Sallen und Key - Filter (11) zweiter Ordnung.

6. Anordnung nach Anspruch 1, **dadurch gekennzeichnet,**
**daß** Auskoppelstufen (6;7) vorgesehen sind, welche demodulierte Niederfrequenz-Tonsignale liefern, wobei den Auskoppelstufen (6;7) eingangsseitig jeweils das Eingangssignal des spannungsgesteuerten Oszillators (20;60) einer der Phasenregelkreise (1;2) zugeführt wird.

7. Anordnung nach Anspruch 1, **dadurch gekennzeichnet,**
**daß** die Schmalband-Phasenregelkreise (1;2) eingangsseitig jeweils einen Phasendiskriminator (18;58) aufweisen, dessen Ausgangssignal jeweils auf ein Schleifenfilter (28;68) und einen Steuereingang (19;59) eines spannungsgesteuerten Oszillators (20;60) gekoppelt ist, welcher an zwei Ausgängen (21,23;61,63) Signale mit 0° oder 180° und mit 90° Phasenverschiebung liefert, wobei das Signal mit 90°-Phasenlage auf einen zweiten Eingang (22;62) des Phasendiskriminators des Phasenregelkreises (1;2) gekoppelt ist.

8. Anordnung nach Anspruch 7, **dadurch gekennzeichnet,**
**daß** die Schmalband-Phasenregelkreise (1;2) jeweils eine digitale Fanghilfe aufweisen, welche die Frequenz des spannungsgesteuerten Oszillators (20;60) in einem vorgegebenen Frequenzbereich hält.

9. Anordnung nach den Ansprüchen 2, 4 und 7, **dadurch gekennzeichnet,**
**daß** das Ausgangssignal mit 0°/180°-Phasenlage des spannungsgesteuerten Oszillators (20) des ersten Phasenregelkreises (1) auf den zweiten Eingang (45) der Überlagerungsstufe der Trägerunterdrückungsschaltung (3) gekoppelt ist und daß die Ausgangssignale mit 90°-Phasenlage der spannungsgesteuerten Oszillatoren (20;60) der beiden Phasenregelkreise (1;2) jeweils auf einen Eingang (24;64) des Phasendiskriminators (25;65) der jeweils vorgeschalteten Verstärkungsstufe (4;5) gekoppelt sind.

## Claims

1. A stereo/two-tone demodulator for demodulating an intermediate-frequency signal comprising stereo or two-tone sound signals modulated on a first and a second sound carrier, the second sound carrier having a lower amplitude than the first sound carrier, **characterized in that** a first (1) and a second (2) linear narrow-band phase-locked loop are provided each having their own frequency selectivity, the first narrow-band phase-locked loop (1) being implemented in such a way that it locks in at the frequency of the first sound carrier, and the second narrow-band phase-locked loop (2) being implemented in such a way that it locks in at the frequency of the second sound carrier, **in that** the first narrow-band phase-locked loop (1) is preceded by a first amplifier stage (4) and the second narrow-band phase-locked loop (2) is preceded by a second amplifier stage (5), each controlling the input signal of the subsequent phase-locked loop (1; 2) at a nominal amplitude, and **in that** a carrier suppression circuit (3) is provided in which an output signal having a phase position of 0° or 180° of a voltage-controlled oscillator (20) of the first narrow-band phase-locked loop (1) and the input signal of the first narrow-band phase-locked loop (1) are superimposed and which supplies a modified intermediate-frequency signal as an output signal in which the first sound carrier is suppressed and which is coupled to the second amplifier stage (5) preceding the second narrow-band phase-locked loop (2).

2. An arrangement as claimed in claim 1, **characterized in that** the carrier suppression circuit (3) comprises a superposition stage (43) whose first input (44) is coupled to the input signal of the first narrow-band phase-locked loop (1) and whose second input (45) is coupled to an output signal of a controlled amplifier (42) whose input receives the output signal with 0°/180° phase position of the voltage-controlled oscillator (20) of the first narrow-band phase-locked loop (1) and whose gain is dependent on a control signal which is supplied by an automatic gain control circuit whose input receives the output signal of the superposition stage and the input signal of the controlled amplifier (42), and which generates the control signal in such a way that the first sound carrier occurs with a minimal amplitude in the output signal of the superposition stage (43).

3. An arrangement as claimed in claim 2, **characterized in that** the automatic gain control circuit in the carrier suppression circuit (3) comprises a synchronous demodulator (47), a first input (46) of which receives the output signal of the superposition stage (43) and a second input (48) receives the input signal of the controlled amplifier (42), and whose output (49) supplies the control signal.

4. An arrangement as claimed in claim 1, **characterized in that** the gain control performed in the amplifier stages (4; 5) preceding the two narrow-band phase-locked loops (1; 2) is effected by means of a controlled amplifier (14; 54) whose gain is adjustable in dependence upon an output signal of a synchronous demodulator (25; 65), an input of which receives the input signal of the subsequent phase-locked loop (1; 2) as well as the output signal with 0° phase position of the voltage-controlled oscillator (20; 60).

5. An arrangement as claimed in claim 4, **characterized in that** the intermediate-frequency signal is high-pass filtered in the amplifier stages (4; 5), preferably by means of a third-order filter with a second-order Sallen and Key filter (11).

6. An arrangement as claimed in claim 1, **characterized in that** output stages (6; 7) supplying demodulated low-frequency sound signals are provided, the inputs of said output stages (6; 7) receiving the input signal from the voltage-controlled oscillator (20; 60) of one of the phase-locked loops (1; 2).

7. An arrangement as claimed in claim 1, **characterized in that** the narrow-band phase-locked loops (1; 2) comprise a phase discriminator (18; 58) at their inputs, whose output signal is coupled to a loop filter (28; 68) and to a control input (19; 59) of a voltage-controlled oscillator (20; 60) which supplies signals with 0° or 180° and with 90° phase shifts at two outputs (21, 23; 61, 63), the 90° phase position signal being coupled to a second input (22; 62) of the phase discriminator of the phase-locked loop (1; 2).

8. An arrangement as claimed in claim 7, **characterized in that** the narrow-band phase-locked loops (1; 2) have a digital lock-in means which maintains the frequency of the voltage-controlled oscillator (20; 60) in a predetermined frequency range.

9. An arrangement as claimed in claims 2, 4 and 7, **characterized in that** the output signal with 0°/180° phase position of the voltage-controlled oscillator (20) of the first phase-locked loop (1) is coupled to the second input (45) of the superposition stage of the carrier suppression circuit (3), and **in that** the output signals with 90° phase position of the voltage-controlled oscillators (20; 60) of the two phase-locked loops (1; 2) are coupled to an input (24; 64) of the phase discriminator (25; 65) of the respective preceding amplifier stage (4; 5).

## Revendications

1. Démodulateur stéréo/bicanal pour la démodulation d'un signal de fréquence intermédiaire qui contient des signaux audio stéréo et bicanal modulés sur des première et deuxième porteuses audio, la deuxième porteuse audio présentant une amplitude inférieure à la première porteuse audio, **caractérisé en ce**
**qu'**un premier (1) et un deuxième (2) circuits de réglage de phase à bande étroite linéaires sont prévus et présentent respectivement leur propre sélectivité de fréquence, le premier circuit de réglage de phase à bande étroite (1) étant conçu de telle sorte qu'il se bloque sur la fréquence de la première porteuse audio et le deuxième circuit de réglage de phase à bande étroite (2) étant conçu de telle sorte qu'il se bloque sur la fréquence de la deuxième porteuse audio,
**qu'**un premier étage amplificateur (4) est monté en amont du circuit de réglage de phase à bande étroite (1) et un deuxième étage amplificateur (5) est monté en amont du deuxième circuit de réglage de phase à bande étroite (2) qui règlent respectivement le signal d'entrée du circuit de réglage de phase (1, 2) monté en aval sur une amplitude de consigne et
**qu'**il est prévu un circuit d'affaiblissement de porteuse (3) dans lequel un signal de sortie avec une position de phase de 0° et 180° d'un oscillateur (20) commandé par tension du premier circuit de réglage de phase à bande étroite (1) et le signal d'entrée du premier circuit de réglage de phase à bande étroite (1) sont superposés et qui délivre comme signal de sortie un signal modifié de fréquence intermédiaire dans lequel la première porteuse audio est affaiblie et qui est couplé sur le deuxième étage amplificateur (5) monté en amont sur le deuxième circuit de réglage de phase en bande étroite (2).

2. Dispositif selon la revendication 1, **caractérisé en ce**
**que** le circuit d'affaiblissement de porteuse (3) présente un étage de superposition (43) sur la première entrée (44) duquel est couplé le signal d'entrée du premier circuit de réglage de phase en bande étroite (1) et sur la deuxième entrée (45) duquel est couplé un signal de sortie d'un amplificateur (42) commandé auquel est amené côté entrée le signal de sortie avec une position de phase de 0°/180° de l'oscillateur (20) commandé par tension du premier circuit de réglage de phase (1) à bande étroite et dont l'amplification dépend d'un signal de commande qui est délivré par un circuit en vue du réglage automatique de l'amplification auquel sont amenés coté entrée le signal de sortie de l'étage de superposition et le signal d'entrée de l'amplificateur (42) commandé et qui génère le signal de commande de telle sorte que la première porteuse audio d'amplitude minimale soit présente dans le signal de sortie de l'étage de superposition (43).

3. Dispositif selon la revendication 2, **caractérisé en ce**
**que** le circuit prévu dans le circuit d'affaiblissement de porteuse (3) présente, en vue du réglage automatique de l'amplification, un démodulateur synchrone (47) auquel sont amenés à une première entrée (46) le signal de sortie de l'étage de superposition (43) et à une deuxième entrée (48) le signal d'entrée de l'amplificateur commandable (42) et qui délivre le signal de commande côté sortie (49).

4. Dispositif selon la revendication 1, **caractérisé en ce**
**que** le réglage de l'amplification effectué dans les étages d'amplification (4, 5) respectivement montés en amont des deux circuits de réglage de phase en bande étroite (1, 2) est respectivement effectué à l'aide d'un amplificateur (14, 54) commandé dont l'amplification est réglable en fonction d'un signal de sortie d'un démodulateur synchrone (25 ; 65) auquel sont amenés côté entrée le signal d'entrée du circuit de réglage de phase (1 ; 2) monté en aval ainsi que le signal de sortie avec une position de phase de 0° de son oscillateur (20 ; 60) commandé par tension.

5. Dispositif selon la revendication 4, **caractérisé en ce**
**que**, dans les étages d'amplification (4, 5), il est prévu un filtrage passe-haut du signal de fréquence intermédiaire, de préférence un filtre de troisième ordre avec un filtre de Sallen et Key (11) de deuxième ordre.

6. Dispositif selon la revendication 1, **caractérisé en ce**
**qu'**il est prévu des étages de sortie (6, 7) qui délivrent des signaux audio à basse fréquence démodulés, le signal d'entrée de l'oscillateur (20, 60) commandé par tension d'un des circuits de réglage de phase (1, 2) étant respectivement amené aux étages de sortie (6, 7).

7. Dispositif selon la revendication 1, **caractérisé en ce**
**que** les circuits de réglage de phase en bande étroite (1, 2) présentent respectivement côté entrée un discriminateur de phase (18, 58) dont le signal de sortie est respectivement couplé à un filtre en boucle (28, 68) et à une entrée de commande (19, 59) d'un oscillateur (20, 60) commandé par tension qui délivre aux deux sorties (21, 23, 61, 63) des signaux à 0° ou 180° avec un déphasage de 90°, le signal avec une position de phase de 90° étant couplé à une deuxième entrée (22, 62) du discriminateur de phase du circuit de réglage de phase (1, 2).

8. Dispositif selon la revendication 7, **caractérisé en ce**
**que** les circuits de réglage de phase (1, 2) en bande étroite présentent respectivement un collecteur auxiliaire numérique qui garde la fréquence de l'oscillateur (20, 60) commandé par tension dans une gamme de fréquences préalablement déterminée.

9. Dispositif selon l'une des revendications 2, 4 et 7, **caractérisé en ce**
**que** le signal de sortie avec une position de phase de 0°/180° de l'oscillateur (20) commandé par tension du premier circuit de réglage de phase (1) est couplé sur la deuxième entrée (45) de l'étage de superposition du circuit d'affaiblissement de porteuse (3) et que les signaux de sortie avec une position de phase de 90° des oscillateurs (20, 60) commandés par tension des circuits de réglage de phase (1, 2) sont respectivement couplés à une entrée (24, 64) du discriminateur de phase (25, 65) de l'étage d'amplificateur (4 ) respectivement monté en amont.
